# EUROPEAN PATENT SPECIFICATION

(11) **EP 0 481 483 B1**
(45) Date of publication and mention of the grant of the patent: **12.04.1995**
(21) Application number: 91117743.4
(22) Date of filing: 17.10.1991
(51) Int. Cl.: H01L 33/00, H01L 25/075, H01L 25/16

(54) **Method of manufacturing the front mask of a display device**
Verfahren zur Herstellung der Frontmaske einer Anzeigevorrichtung
Procédé de fabrication de la masque frontal d'un dispositif d'affichage

(30) Priority: 18.10.1990 JP 280861/90
(43) Date of publication of application: 22.04.1992
(73) Proprietor: MITSUBISHI DENKI KABUSHIKI KAISHA, Tokyo (JP)
(72) Inventor: Sawai, Yasuhiko, c/o Nagasaki Jigyosho, Mitsubishi, Nagasaki-shi, Nagasaki-ken (JP)
(74) Representative: KUHNEN, WACKER & PARTNER

(56) References cited:
- GB-A- 2 098 714
- PATENT ABSTRACTS OF JAPAN, vol. 13, no. 531 (E-851)(3879), 28 November 1989 ; & JP-A-1 216 562
- PATENT ABSTRACTS OF JAPAN, vol. 5, no. 181 (E-83)(853), 20 November 1981 ; & JP-A-56 110 275

## Description

The present invention relates to a manufacturing method of a front mask of a display device comprising luminous parts and peripheral parts thereon integratedly resin-molded with a mask main body. In particular, the present invention relates to a manufacturing method of a front mask of a display device in which such display parts of image display device as LED displaying an image, and the peripheral parts are integrated by resin-molding.

From GB-A-2 098 714 a LED cluster assembly in miniature lamp cap for the use instead of a conventional filament lamp is known. A cluster assembly of seven light-emitting diodes with their necessary circuitry and current limiting resistors is assembled into a plastic molding, which in turn is assembled into and connected to a miniature lamp cap. The completed assembly is then filled with a clear epoxy resin.

From Patent Abstracts of Japan, vol. 13, no. 531 (E-851) [3879], 28 November 1989, and JP-A-1 216 562, a hybrid integrated circuit component is shown having a reduced size by placing an optical device component and its peripheral circuit components in the same package, sealing the circuit components with light shielding coloured resin and transfer molding the entirety with transparent resin.

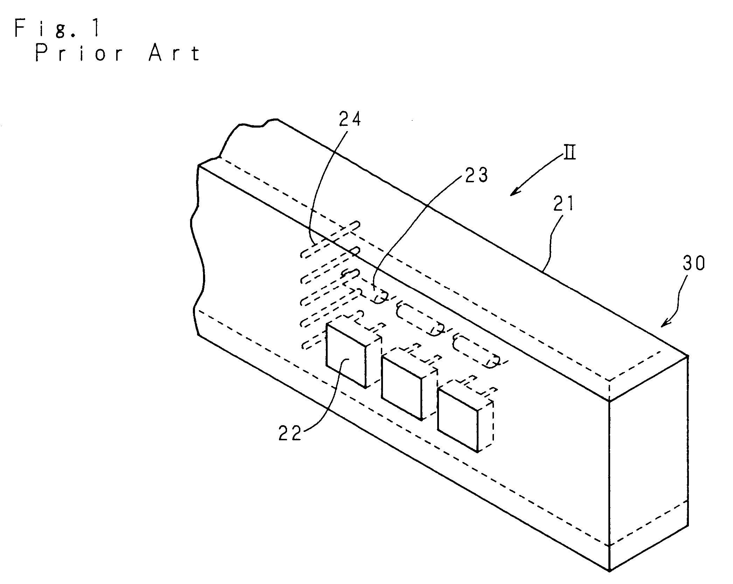

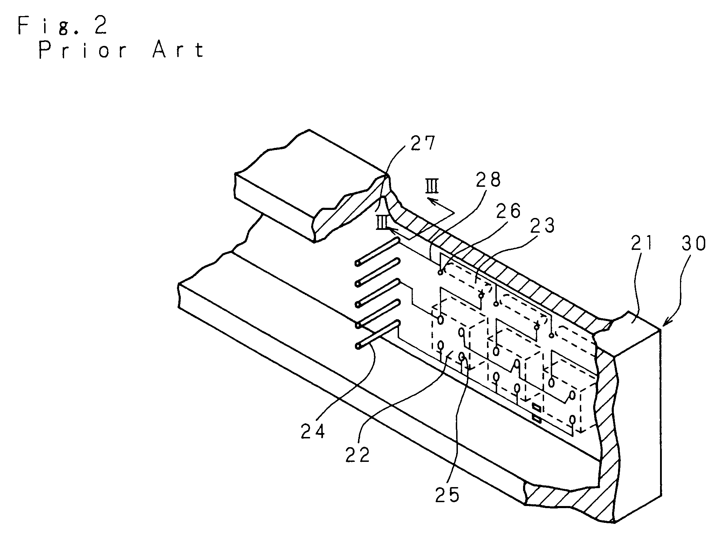

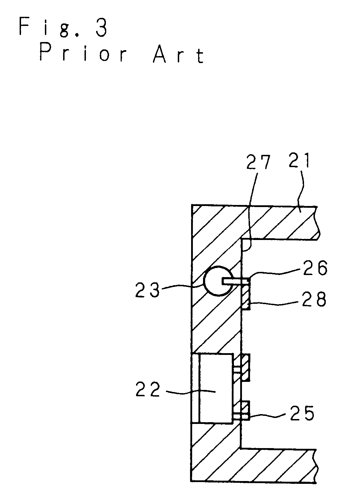

There exists the Japanese Utility Model Application Laid-Open No.62-49192(1987) as a disclosed case of a front mask of display device in which display parts and peripheral parts are integrated by resin-molding. Fig. 1 shows a perspective view of the conventional front mask which has been disclosed as mentioned above. Fig. 2 shows a partially cutaway view of Fig. 1 as seen along the direction II. Fig. 3 shows a sectional view of it as seen along the line III - III of Fig. 2. A front mask 30 has a structural feature that LED 22 which functions as luminous parts and the peripheral parts of the luminous parts including a resistance 23 and a connector 24 to be connected to an external device are integrated by resin-molding. A terminal 25 of LED 22 and a terminal 26 of the resistance 23 project beyond the surface 27 of a mask main body 21. Electrical connection is made between the terminal 25 and the terminal 26, between the terminal 25 and the connector 24 and between the terminal 26 and the connector 24, by a conductor pattern 28 which is formed on the surface 27 by printing.

Description is made below about the manufacturing process of the front mask 30 which has such a structural feature as mentioned above. At first, a mold for forming is prepared. LED 22, the resistance 23 and the connector 24 are installed at the mounting portion, which has been formed at the predetermined position of the mold. Then, liquid resin is injected through an injection opening of the mold. After the resin is hardened, the mold is demolished, and the mask main body 21 which is integrated with each part is taken out. Then, the conductor pattern 28 is formed by printing at the predetermined position on the surface of the mask main body 21 between the terminal 25 and the terminal 26, between the terminal 25 and the connector 24 and between the terminal 26 and the connector 24.

Since the conventional front mask 30 of the display device is constructed in such a way as mentioned above, LED 22, the resistance 23 and the connector 24 are integrated with the mask main body 21. This makes it possible to manufacture with a high level of accuracy in size. There, however, exist problems that since the connection between these parts is made by the printed conductor pattern 28, the printing process is complicated, and that since each part should be arranged by considering the level of printing performance of the conductor pattern 28, there is a considerable limitation in the degree of freedom in the arrangement of each part and design.

### SUMMARY OF THE INVENTION

The front mask of a display device manufactured by the method of the present invention in accordance with claim 1 has a structural feature that the luminous parts (LED) and the peripheral parts (the connector and the like) are integrated by resin-molding while they are set in an electrically connected condition by a film insulated wire in advance. Each part is placed at the predetermined position of a mold prior to the resin-molding process. Then, electrical connection is made between the corresponding parts by using the film insulated wire. After the process, resin is injected to manufacture an integrated body.

One object of the present invention is to provide a method of manufacturing a front mask of a display device which makes it possible to improve operation in the manufacturing process.

Another object of the present invention is to provide a method of manufacturing a front mask of a display device which makes it possible to improve the degree of freedom in the arrangement of each part.

The above and further objects and features of the invention will more fully be apparent from the following detailed description with accompanying drawings.

### BRIEF DESCRIPTION OF THE DRAWINGS

Fig. 1 shows a perspective view of the conventional front mask of a display device,
Fig. 2 shows a partially cutaway view of it as seen along the direction II of Fig. 1,
Fig. 3 shows a sectional view of it as seen along the line III - III of Fig. 2,
Fig. 4 shows a perspective view of the front mask of a display device manufactured according to the present invention,
Fig. 5 shows a sectional view of it as seen along the line V - V of Fig. 4, and
Fig. 6(a), 6(b) show schematic views showing the procedure of resin-molding in the manufacturing process of the present invention.

### DESCRIPTION OF THE PREFERRED EMBODIMENTS

The present invention will be below described in detail with reference to the drawings.

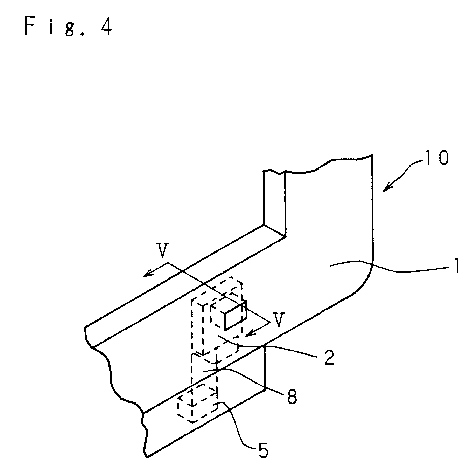

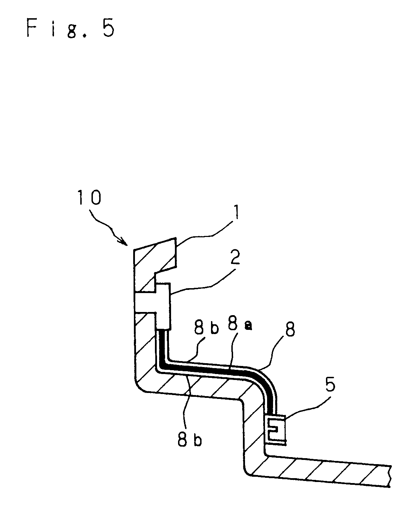

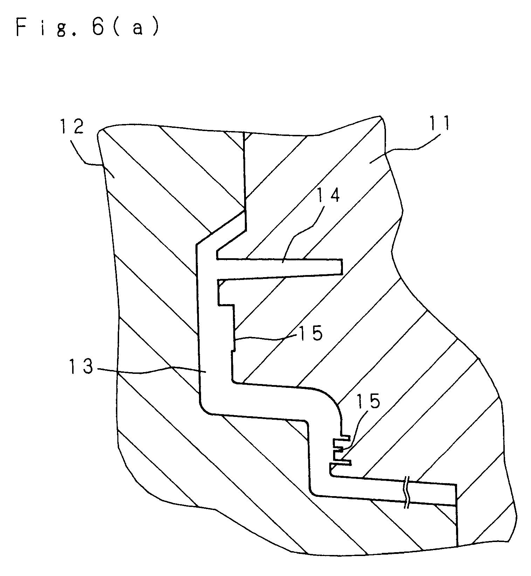

Figs. 4 and 5 show a preferred embodiment manufactured according to the present invention. Reference numeral 10 in the drawing shows a front mask in which LED 2 and a connector 5 are integrated with a mask main body 1 by resin-molding with epoxy resin and the like. LED 2 and the connector 5 are electrically connected by a film insulated wire 8 which is integrated with the mask main body 1.

The film insulated wire 8 is formed in an integrated body which is made of a plurality of conductors or insulated wires running in parallel to each other. As a conductor, a thin annealed copper wire, a twined annealed copper wire, a copper foil or the like is used. The processing of film is made in the method in which adhesion is made by such adhesives as PVC (Polyvinyl Chloride) among the insulated wires which are laid out in parallel to each other, or the method in which a conductor is sandwiched between insulating tapes and then heat-pressed. The insulating tape which has a lamination of low melting point polyethylene and the like over one side of polyester tape is used as material in this process. The film insulated wire 8 which is used in this preferred embodiment has a structural feature that a conductor 8a is sandwiched between two sheets of insulating tapes 8b and 8b.

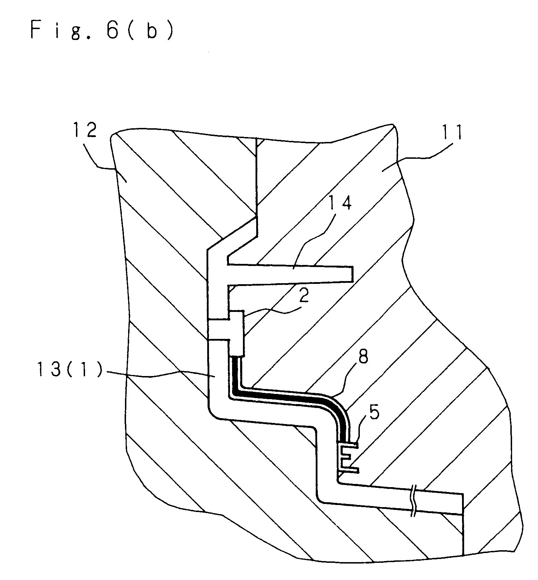

Description is made below about the manufacturing process of the front mask which has the above mentioned structural feature, especially the resin-molding process, by referring to Fig. 6. Fig. 6(a) shows a mold for forming to be used in the resin-molding process. This mold is comprised of the metal mold 11 on the core side and the metal mold 12 on the cavity side. A cavity 13 is established in the position between the molds 11 and 12 in a way that the cavity 13 fits the shape of the front mask to be manufactured. A resin injection opening 14 is established which communicates with the cavity 13. In addition, mounting portions 15 for positioning are provided on the mold 11 on the core side to install the connector, LED and the like.

Parts including LED 2, connector 5 are installed on the mounting portions 15 which is provided at the predetermined position of the mold for forming which has the above mentioned structural feature. Then, electrical connection is made between parts including LED 2 and the connector 5 by using the film insulated wire 8. Fig. 6(b) shows the condition of these parts after the electrical connection. Then, liquid resin is injected through the resin injection opening 14. When resin is hardened, the molds 11 and 12 are demolished and the front mask 10 as shown in Figs. 4 and 5 is manufactured.

In the above mentioned manufacturing process, electrical connection is made between the corresponding parts by the film insulated wire 8 after each part is set on the mounting portion 15. It is, however, possible to mount these parts as an integrated body at the predetermined position of the mold after conducting electrical connection between the corresponding parts by the film insulated wire 8, and then carry out resin-molding.

The front mask 10 which is taken out of the mold has a structural feature that LED 2 and the connector 5 are integratedly resin-molded with the mask main body 1. At this point of time, the film insulated wire 8 is also integratedly resin-molded with the mask main body 1. As a result, it does not involve such complicated work of printing on the narrow surface of resin after molding as that of the conventional manufacturing method. This significantly improves operation in the manufacturing process of the front mask.

In addition, a higher degree of freedom is obtained with regard to the arrangement of each part of the front mask than that of the conventional method since the connecting operation using the film insulated wire 8 can be made without restriction if there is a given space between these parts. As a result, restriction in operation of the design work of a display device with a front mask, even that of architectural design which is relatively important, can be considerably reduced when compared to the conventional method.

Furthermore, since the film insulated wire 8 is employed in the process, it is possible to produce in almost same level of thickness as that of the printing wire of the conventional method. This makes it possible to produce the unit not only in a compact size but also in excellent appearance.

## Claims

1. A manufacturing method of a front mask of a display device, the mask comprising luminous parts (2) and peripheral parts (5) which are integrated by resin-molding, comprising the steps of:
(a) preparing a mold (11, 12) which has a cavity (13) fitting the shape of said front mask (10) to be manufactured, has a mounting portion (15) for positioning said luminous parts (2) and said peripheral parts (5), and a resin injection opening (14);
(b) installing said luminous parts (2) and said peripheral parts (5) at said mounting portion (15) of said mold (11, 12);
(c) connecting said luminous parts (2) and said peripheral parts (5) by a film-insulated wiring (8);
(d) after the steps (b) and (c), injecting resin through said resin injection opening (14) of said mold (11, 12); and
(e) demolishing said mold (11, 12) after the injected resin is hardened.

2. A manufacturing method as set forth in Claim 1, wherein said luminous parts (2) include an LED (Light Emitting Diode).

3. A manufacturing method as set forth in Claims 1 or 2, wherein said peripheral parts (5) include a connector to be connected to an external device.

4. A manufacturing method as set forth in one of Claims 1 through 3, wherein said film-insulated wiring (8) includes two sheets of insulating tapes (8b) and a plurality of conductors (8a) running parallel to each other and being sandwiched between said insulating tapes (8b).

5. A manufacturing method as set forth in Claim 4, wherein said insulating tapes (8b) have a lamination of polyethylene and polyester.

6. A manufacturing method as set forth in Claims 4 or 5, wherein said conductor (8a) is one selected from a group consisting of a thin annealed copper wire, a twined annealed copper wire and a copper foil.

## Patentansprüche

1. Herstellungsverfahren einer Frontmaske einer Anzeigevorrichtung, wobei die Maske Leuchtteile (2) und Umfangsabschnittsteile (5) umfaßt, welche mittels Harzvergießen zusammengefaßt sind, mit den folgenden Schritten:
**(a)** Vorbereiten einer Form (11, 12), welche einen Hohlraum (13), der der Form der herzustellenden Frontmaske (10) angepaßt ist, aufweist, einen Befestigungsabschnitt (15) zum Positionieren der Leuchtteile (2) und der Umfangsabschnittsteile (5) und eine Harzeinspritzöffnung (14) aufweist;
**(b)** Installieren der Leuchtteile (2) und der Umfangsabschnittsteile (5) an den Befestigungsabschnitten (15) der Form (11, 12);
**(c)** Verbinden der Leuchtteile (2) und der Umfangsabschnittsteile (5) durch eine filmisolierte Verdrahtung (8);
**(d)** Einspritzen von Harz durch die Harzeinspritzöffnung (14) der Form (11, 12) nach den Schritten (b) und (c); und
**(e)** Zerstören der Form (11, 12), nachdem das eingespritzte Harz ausgehärtet ist.

2. Herstellungsverfahren nach Anspruch 1, bei dem die Leuchtteile (2) eine LED (lichtabstrahlende Diode) beinhalten.

3. Herstellungsverfahren nach Anspruch 1 oder 2, bei dem die Umfangsabschnittsteile (5) ein Verbindungsstück beinhalten, das mit einer äußeren Vorrichtung zu verbinden ist.

4. Herstellungsverfahren nach einem der Ansprüche 1 bis 3, bei dem die filmisolierte Verdrahtung (8) zwei Lagen von isolierenden Streifen (8b) und eine Vielzahl von Leitern (8a), die zueinander parallel verlaufen und zwischen den isolierenden Streifen (8b) beidseitig umfaßt werden, beinhaltet.

5. Herstellungsverfahren nach Anspruch 4, bei dem die isolierenden Streifen (8b) eine Beschichtung von Polyäthylen oder Polyester aufweisen.

6. Herstellungsverfahren nach Anspruch 4 oder 5, bei dem der Leiter (8a) einer ist, der aus einer Gruppe, die aus einem dünnen ausgeglühten Kupferdraht, einem verdrehten ausgeglühten Kupferdraht und einer Kupferfolie besteht, ausgewählt ist.

## Revendications

1. Méthode de fabrication d'un masque avant d'un dispositif de visualisation, le masque comprenant des parties lumineuses (2) et des parties périphériques (5) qui sont intégrées par moulage dans la résine, comprenant les étapes de :
(a) préparer un moule (11, 12) qui a une cavité (13) s'adaptant à la forme dudit masque avant (10) à fabriquer, qui a une portion de montage (15) pour le positionnement desdites parties lumineuses (2) et desdites parties périphériques (5) et une ouverture (14) d'injection de la résine ;
(b) installer lesdites parties lumineuses (2) et lesdites parties périphériques (5) à ladite position de montage (15) dudit moule (11, 12) ;
(c) connecter lesdites parties lumineuses (2) et lesdites parties périphériques (5) par un câblage (8) isolé par un film ;
(d) après les étapes (b) et (c), injecter de la résine par ladite ouverture d'injection de résine (14) dudit moule (11, 12) ; et
(e) démolir le moule (11, 12) après durcissement de la résine injectée.

2. Méthode de fabrication selon la revendication 1 où lesdites parties lumineuses (2) comprennent une LED (diode photoémettrice).

3. Méthode de fabrication selon les revendications 1 ou 2, où lesdites parties périphériques (5) comprennent un connecteur à connecter à un dispositif externe.

4. Méthode de fabrication selon l'une quelconque des revendications 1 à 3, où ledit fil (8) isolé par un film comprend deux morceaux de rubans isolants (8b) et un certain nombre de conducteurs (8a) passant parallèlement les uns aux autres et qui sont pris en sandwich entre lesdits rubans isolants (8b).

5. Méthode de fabrication selon la revendication 4, où lesdits rubans isolants (8b) ont un feuilletage de polyéthylène et de polyester.

6. Méthode de fabrication selon les revendications 4 ou 5, où ledit conducteur (8a) est choisi dans le groupe consistant en un fil de cuivre recuit mince, un fil de cuivre recuit retors et une feuille de cuivre.
